# EUROPÄISCHE PATENTANMELDUNG

(11) **EP 1 772 594 A1**
(43) Veröffentlichungstag der Anmeldung: **11.04.2007**
(21) Anmeldenummer: 05021593.8
(22) Anmeldetag: 04.10.2005
(51) Int. Cl.: F01D 5/28, C23C 14/04

(54) **Verfahren zum Schützen von Öffnungen eines Bauteils bei einem Bearbeitungsprozess gegen ein Eindringen von Material und Polysiloxan enthaltende keramische Zusammensetzung**

(71) Anmelder: SIEMENS AKTIENGESELLSCHAFT, 80333 München (DE)
(72) Erfinder: Jabado, Rene, 14199 Berlin (DE); Körtvelyessy, Daniel, 13469 Berlin (DE); Reiche, Ralph, 13465 Berlin (DE); Rindler, Michael, 15566 Schöneiche (DE); Walter, Steffen, Dr., 85630 Harthausen (DE)

(57) **Zusammenfassung**

Im erfindungsgemäßen Verfahren zum Schützen von Öffnungen (14, 16) eines aus einem elektrisch leitfähigen Grundwerkstoff, insbesondere aus Metall oder einer Metalllegierung, hergestellten Bauteils (10) bei einem Bearbeitungsprozess gegen ein Eindringen von Material werden die Öffnungen (14, 16) vor dem Bearbeitungsprozess mit einem Füllmaterial (20, 22) verschlossen, welches nach dem Bearbeitungsprozess wieder entfernt wird.

Das erfindungsgemäße Verfahren zeichnet sich dadurch aus, dass als Füllmaterial (20, 22) Ketten aus Si-O-Si und/oder Si-O-C verwendet werden.

## Beschreibung

Die vorliegende Erfindung betrifft ein Verfahren zum Schützen von Öffnungen eines Bauteils bei einem Bearbeitungsprozess gegen ein Eindringen von Material, in dem die Öffnungen vor dem Bearbeitungsprozess mit einem Füllmaterial verschlossen werden. Daneben betrifft die Erfindung einen keramischen Werkstoff, insbesondere zur Verwendung als Füllmaterial im erfindungsgemäßen Verfahren.

Thermisch hoch belastete Bauteile, beispielsweise Turbinenschaufeln von Gasturbinen, werden häufig zur Kühlung mit einem Kühlfilm überzogen. Dazu umfassen diese Bauteile im Inneren angeordnete Kühlfluidkanäle, die ein Kühlfluid transportieren, welches zum Aufbau des Kühlfilms Verwendung findet. Um das Kühlfluid, beispielsweise Luft, aus dem Inneren des Bauteils herauszuleiten, damit es den Kühlfilm bilden kann, sind Öffnungen im Bauteil, die beispielsweise als Kühlluftbohrungen ausgeführt sind, vorhanden. Diese Öffnungen ermöglichen einen Durchtritt des Kühlfluids aus dem Inneren des Bauteils nach außen. Die Querschnittsfläche und die Form der Öffnungen sind dabei so ausgelegt, dass zum einen die benötigte Menge an Kühlfluid aus dem Bauteil strömt und sich zum anderen ein geeigneter Kühlfluidfilm auf der Bauteiloberfläche bildet.

Die beschriebenen thermisch hoch belasteten Bauteile sind darüber hinaus mit Beschichtungen versehen, beispielsweise mit einer MCrAlX-Beschichtung, also einer Beschichtung, welche Chrom (Cr), Aluminium (Al), Yttrium (X=Y) und ein weiteres Metall (M) umfasst. Diese Beschichtung dient zum Schutz der Bauteile gegen Oxidation und/oder Korrosion. Zudem können die Bauteile zur thermischen Isolation mit einer thermischen Isolationsbeschichtung, im Folgenden kurz TBC-Schicht (Thermal Barrier Coating) genannt, beschichtet sein.

Der Betrieb der Bauteile führt dazu, dass die Beschichtung bzw. die Beschichtungen verschleißen, und zwar häufig bereits bevor die strukturelle Integrität des Bauteils soweit vermindert ist, dass es nicht mehr weiter betrieben werden kann. Die Bauteile werden daher neu beschichtet, um sie einer Weiterverwendung zuzuführen. Aber auch dann, wenn lediglich eine Prüfung des Bauteils, z.B. auf strukturelle Defekte, vorgenommen werden soll, kann eine Neubeschichtung notwendig werden, nämlich dann, wenn für das Prüfen des Bauteils alle Beschichtungen entfernt werden müssen. Beim Wiederbeschichten besteht dabei die Problematik, dass Kühlluftbohrungen mit dem Beschichtungsmaterial, beispielsweise MCrAlX, verschlossen oder in ihrem Durchmesser reduziert werden. Die Reduktion des Durchmessers verringert dabei die Austrittsfläche der Öffnung, wodurch sich die Kühlwirkung durch den Kühlfilm verändert und ggf. verringert. Zudem kann, wenn die Austrittsfläche der Öffnung zu klein wird, die für die Kühlwirkung erforderliche Strömung, die beispielsweise laminar oder turbulent ist, nicht mehr gewährleistet werden. In beiden Fällen führt dies zum vorzeitigen Versagen des Bauteils aufgrund Überhitzung. Das Verringern des Durchmessers der Öffnungen wird auch "Coat-Down-Effekt" genannt.

Eine Möglichkeit, dem Coat-Down-Effekt zu begegnen, besteht darin, die nach dem Wiederbeschichten zur Verringerung des Öffnungsdurchmessers führende Beschichtung auf der Innenseite der Öffnung per Hand, beispielsweise mittels einer Diamantfeile, oder mit einem Laser zu entfernen. Zum Teil werden während des Beschichtungsvorgangs auch Quarzstifte in Kühlluftbohrungen eingesetzt, welche anschließend mittels einer Säure oder einer Lauge ausgewaschen werden müssen. Außerdem ist in der Literatur auch das Wiederöffnen von Kühlluftbohrungen mittels EDM oder Strömungsschleifen beschrieben.

Weiterhin sind Verfahren beschrieben, in denen Kühlluftbohrungen von Gasturbinenkomponenten vor dem Beschichten mittels eines Maskierungsmaterials, welches in die Kühlluftbohrungen eingefüllt wird, verschlossen werden. Anschließend wird das Material aushärten gelassen. Der Beschichtungsprozess wird mit den so geschützten Kühlluftbohrungen durchgeführt. Anschließend wird das Maskierungsmaterial wieder entfernt. In US 5,902,647 und EP 1 076 106 sind beispielsweise Verfahren beschrieben, in denen das Maskierungsmaterial derart in die Löcher eingefüllt wird, dass es über die äußere Oberfläche des Turbinenbauteils übersteht. Dabei ist es jedoch schwierig, sicherzustellen, dass sich das Maskierungsmaterial lateral nicht über die Lochkante hin erstreckt, so dass die Beschichtung nach dem Wiederbeschichten auch tatsächlich bis zur Lochkante reicht.

Auch in der US 4,726,104 wird ein Verfahren beschrieben, bei dem eine Maskierung in Kühlluftbohrungen eingebracht wird.

Die US-PS 3,099,578 offenbart eine elektrisch leitende Zusammensetzung aus Kohlenstoff und Silber, die in einem Harz miteinander vermischt sind.

Die JP 2003342707 offenbart ein Verfahren zum Beschichten einer äußeren Fläche, wobei in der äußeren Fläche Löcher vorhanden sind, die mit einem Gemisch aus einem metallischen Material und einem Harz gefüllt werden.

Die JP 2003306760 offenbart ebenfalls ein Maskierungsverfahren von Löchern, die aus einem mit Kohlenstoff beschichteten metallischen Stab geschützt werden.

In WO03/089679 ist ein Verfahren beschrieben, in dem das Maskierungsmaterial derart in die Kühlluftbohrungen einer Turbinenschaufel eingefüllt wird, dass seine Oberfläche bündig mit der Oberfläche des Turbinenbauteils abschließt. Durch geeignete Wahl des Maskierungsmaterials und von Füllmaterialien im Maskierungsmaterial wird dabei sichergestellt, dass das Beschichtungsmaterial auf dem Maskierungsmaterial nicht haftet. Hier wird ein zweistufiges Verfahren angewendet, um die Kühlluftbohrung zu verschließen. Zuerst wird eine verformbare Masse eingebracht, die dann in einem zweiten Schritt ausgehärtet werden muss.
Außerdem bilden die Polymere, die Teil des Füllmaterials sind, beim Ausbrennen, Russstreifen auf dem Bauteil.

Aufgabe der vorliegenden Erfindung ist es, ein gegenüber dem Stand der Technik verbessertes Verfahren zum Schützen von Öffnungen eines Bauteils gegen ein Eindringen von Beschichtungsmaterial bei einem Beschichtungsprozess zur Verfügung zu stellen.

Eine weitere Aufgabe der vorliegenden Erfindung ist es, einen keramischen Werkstoff zur Verfügung zu stellen, welcher vorteilhafte Eigenschaften aufweist und sich insbesondere zur Verwendung im erfindungsgemäßen Verfahren eignet.

Die erste Aufgabe wird durch ein Verfahren nach Anspruch 1 gelöst, die zweite Aufgabe durch einen keramischen Werkstoff nach Anspruch 18.

Die abhängigen Ansprüche enthalten vorteilhafte Ausgestaltungen des Verfahrens bzw, des keramischen Werkstoffes und können beliebig in vorteilhafter Art und Weise miteinander kombiniert werden.

Im erfindungsgemäßen Verfahren zum Schützen von Öffnungen eines Bauteils bei einem Bearbeitungsprozess gegen ein Eindringen von Material werden die Öffnungen vor dem Bearbeitungsprozess mit einem Füllmaterial verschlossen, welches nach dem Bearbeitungsprozess wieder entfernt wird. Als Bearbeitungsprozesse kommen dabei insbesondere Beschichtungsprozesse und Lötprozesse in Frage.
Das erfindungsgemäße Verfahren zeichnet sich dadurch aus, dass das Füllmaterial als zumindest einen Füllstoff Si-O-C-Ketten oder Si-O-Si-Ketten, vorzugsweise aus Polysiloxan, umfasst.

Besonders vorteilhaft ist es, wenn als Füllmaterial ein Füllmaterial Verwendung findet, dessen Leitfähigkeit der des Grundwerkstoffes entspricht, also bis zu 50% der elektrischen Leitfähigkeit des Grundwerkstoffes.

Der Vorteil des erfindungsgemäßen Verfahrens gegenüber den bisherigen Verfahren besteht darin, dass der Bearbeitungsprozess durch das Füllmaterial weniger beeinträchtigt wird. Beispielsweise erfolgt während eines MCrAlX-Beschichtungsprozesses ein sog. Reinigungssputtern, in dem das Bauteil einem Lichtbogen ausgesetzt wird. Aufgrund der an den Grundwerkstoff angepassten Leitfähigkeit des Füllmaterials wird der Lichtbogen an den Übergängen zwischen der Oberfläche des Grundwerkstoffes und der Oberfläche des Füllmaterials nicht wesentlich beeinträchtigt. Eine Beeinträchtigung könnte zu Schäden im Bauteil führen. Viele Bearbeitungsprozesse, etwa Beschichtungsprozesse mit MCrAlX, umfassen außerdem mindestens einen Aufheizprozess. Aufgrund der an den Grundwerkstoff angepassten Leitfähigkeit des Füllmaterials wird der Wärmeeintrag in das Bauteil an den Übergängen zwischen dem Grundwerkstoff und dem Füllmaterial nicht gestört.

Als Füllmaterial findet vorzugsweise ein aushärtbares Füllmaterial, insbesondere ein keramisches Füllmaterial, Verwendung, um die Festigkeit bzw. die Stabilität des in die Öffnungen eingefüllten Füllmaterials während des Bearbeitungsprozesses zu erhöhen. Das Aushärten erfolgt nach dem Füllen der Öffnungen mit dem Füllmaterial. Wenn das aushärtbare Füllmaterial ein keramisches Füllmaterial ist, wird beispielsweise ein im Rahmen eines Beschichtungsprozesses aufzubringendes Beschichtungsmaterial aufgrund der keramischen Eigenschaften des Füllmaterials nicht oder nur bedingt am Füllmaterial haften. Dies gilt in besonderem Maße für MCrAlX-Beschichtungen.

Das Aushärten des Füllmaterials kann durch eine geeignete Wärmebehandlung erzielt werden. In vorteilhafter Weise kann die Wärmebehandlung durch eine im Rahmen des Bearbeitungsprozesses durchgeführte Wärmebehandlung realisiert bzw. in eine solche Wärmebehandlung integriert werden, so dass ein zusätzlicher Wärmebehandlungsschritt nicht nötig ist.

Das aushärtbare Füllmaterial kann in mindestens einen Teil der Öffnungen insbesondere als Paste eingebracht werden. Das Einbringen der Paste, das beispielsweise mittels einer Spachtelvorrichtung erfolgen kann, bietet den Vorteil, dass beliebig geformte Löcher auf diese Weise verfüllt werden können.

Alternativ oder zusätzlich ist es aber auch möglich, in mindestens einen Teil der Öffnungen vorgeformte zumindest teilvernetzte Füllkörper oder Füllkörper, die nicht mehr wärmebehandelt werden müssen und bspw. mechanisch in den Kühlluftbohrungen haften, einzubringen.
Teilvernetzte Füllkörper sind Füllkörper, die ein Bindemittel auf Polymerbasis umfassen, welches eine teilvernetzte Polymer-Architektur aufweist. Ein teilvernetzter Zustand wird auch als "Grünzustand" bezeichnet und bietet gegenüber einer Paste eine höhere Formstabilität, sodass das Material bereits vor dem Aushärten eine körperliche Form aufrechterhalten kann. Das Verfüllen von Öffnungen mittels derartiger teilvernetzter Füllkörper eignet sich insbesondere zum Einbringen des Füllmaterials in große Öffnungen, wie sie beispielsweise im Bereich der Schaufelbasis von Turbinenschaufeln vorkommen können. Außerdem können mittels teilvernetzter Füllkörper auch gekrümmte Bauteilflächen ganzflächig geschützt werden, beispielsweise wenn die teilvernetzten Füllkörper in Form von Tapes oder Folien vorliegen.

Die Materialeigenschaften des aushärtbaren Füllmaterials und/oder die Aushärtungsbedingungen können derart gewählt sein, dass das Füllmaterial nur teilweise aushärtet. Wenn die Materialeigenschaften und/oder die Aushärtungsbedingungen so gewählt werden, dass das Füllmaterial lediglich im Bereich der Kontaktzonen zum Grundwerkstoff des Bauteils aushärtet, im Volumen des Füllmaterials aber nur teilvernetzt wird oder teilvernetzt bleibt, kann das Entfernen des Füllmaterials nach dem Bearbeitungsprozess mittels eines geeigneten Strahlverfahrens, insbesondere mittels eines CO₂-Strahlverfahrens, erfolgen. In einem Strahlverfahren wird ein geeignetes Material, beispielsweise CO₂ (Kohlendioxid) in Form von Trockeneis, unter Druck auf das Bauteil geblasen, um das Füllmaterial aus den Öffnungen zu entfernen. Das Entfernen des Füllmaterials mittels Trockeneisstrahlen beeinträchtigt etwa eine MCrAlX-Beschichtung nicht. Außerdem ist ein "Auswaschen" der Beta-Phase einer MCrAlX-Beschichtung beim Entfernen des Füllmaterials mittels Trockeneisstrahlen gänzlich ausgeschlossen.

Ein erfindungsgemäßer keramischer Werkstoff, der insbesondere als Füllmaterial in dem erfindungsgemäßen Verfahren Verwendung finden kann, enthält Ketten aus Si-O-Si und/oder Si-O-C.

Im erfindungsgemäßen keramischen Werkstoff lässt sich durch geeignetes Zusammenstellen des Bindemittels und des Füllstoffes, insbesondere durch geeignete Wahl der elektrisch leitfähigen Komponente, die Leitfähigkeit des ausgehärteten Werkstoffes gezielt einstellen. So bietet der Werkstoff die Möglichkeit, seine Leitfähigkeit an die Leitfähigkeit des Grundwerkstoffes desjenigen Bauteils, in dessen Öffnungen er eingefüllt werden soll, anzupassen. Die keramischen Eigenschaften des Werkstoffes sorgen dabei dafür, dass mögliche Beschichtungen auf der Oberfläche des aushärtbaren Werkstoffes schlecht haften, wodurch er sich insbesondere zur Verwendung im erfindungsgemäßen Verfahren eignet.

Als Bindemittel kann der erfindungsgemäße keramische Werkstoff insbesondere einen Kohlenstoff-Precursor umfassen, In diesem Fall kann der Kohlenstoff des Kohlenstoff-Precursors die Leitfähigkeit nach dem Aushärten herstellen. Es braucht dem Füllstoff dann kein Metallpulver zugesetzt zu werden.

Alternativ ist es auch möglich, dass der Füllstoff ein Metallpulver als elektrisch leitfähige Komponente umfasst, welches die elektrische Leitfähigkeit herstellt.

Der keramische Werkstoff kann ein Lösungsmittel zum Herstellen einer Dispersion des Bindemittels und des Füllstoffes umfassen. Das Verwenden des Lösungsmittels ermöglicht es, einen keramischen Werkstoff vor dem Aushärten fließfähig auszugestalten und so das Einstreichen oder Einspritzen des Werkstoffes in Öffnungen zu ermöglichen. Als Lösungsmittel kommen beispielsweise Alkohol oder Terpeniol in Frage.

In einer vorteilhaften Weiterbildung des keramischen Werkstoffes umfasst der Füllstoff Partikel in mindestens zwei Partikelgrößen, wobei die Partikelgrößen insbesondere im Nanometerbereich (insbesondere kleiner 0,1 µm) und/oder Mikrometerbereich liegen. Durch Verwenden von Partikeln unterschiedlicher Größe lässt sich der Füllstoffanteil im keramischen Werkstoff erhöhen.

Weitere Merkmale, Eigenschaften und Vorteile der vorliegenden Erfindung ergeben sich aus der nachfolgenden Beschreibung eines Ausführungsbeispiels unter Bezugnahme auf die beiliegenden Zeichnungen.
- Figur 1: zeigt in schematisierter Darstellung einen Ausschnitt aus einer Turbinenschaufel mit Kühlluftbohrungen,
- Figur 2: zeigt ein erstes Beispiel für das Einbringen des erfindungsgemäßen aushärtbaren Werkstoffes in die Kühlluftbohrungen von Turbinenschaufeln,
- Figur 3: zeigt ein zweites Beispiel für das Einbringen des erfindungsgemäßen aushärtbaren Werkstoffes in die Kühlluftbohrungen von Turbinenschaufeln,
- Figur 4: zeigt eine perspektivische Ansicht einer Turbinenschaufel,
- Figur 5: zeit eine perspektivische Ansicht einer Brennkammer und
- Figur 6: zeigt eine Turbine.

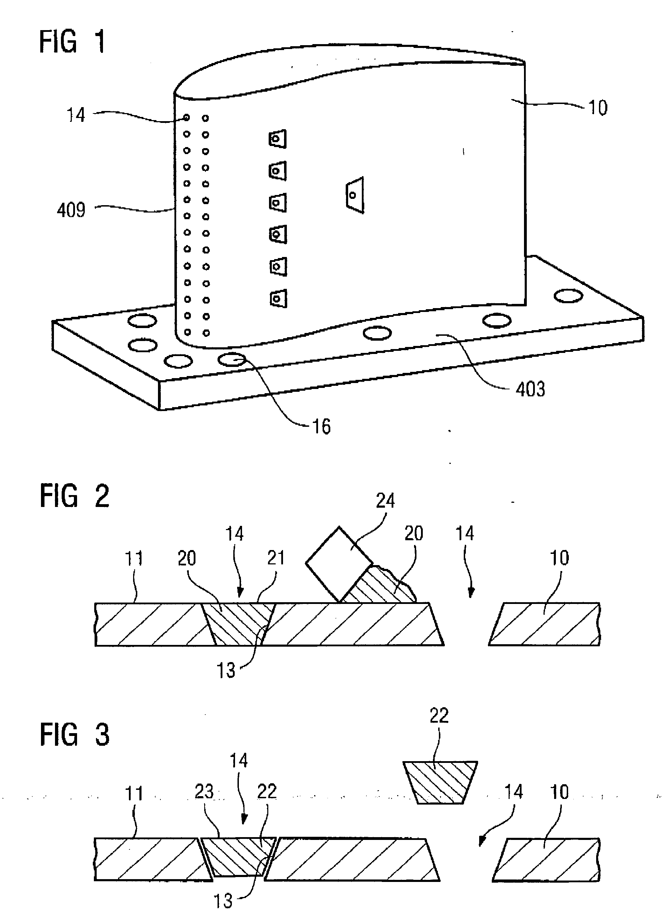

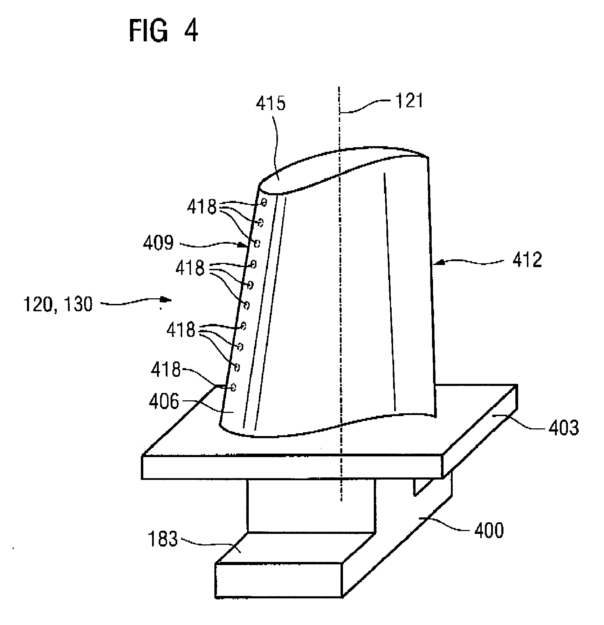

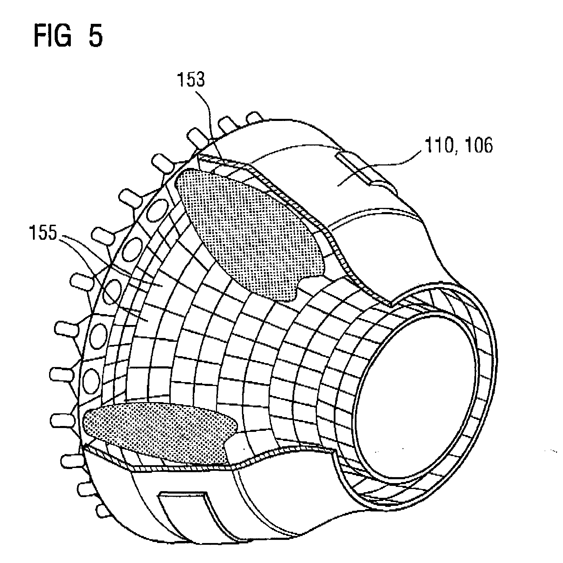

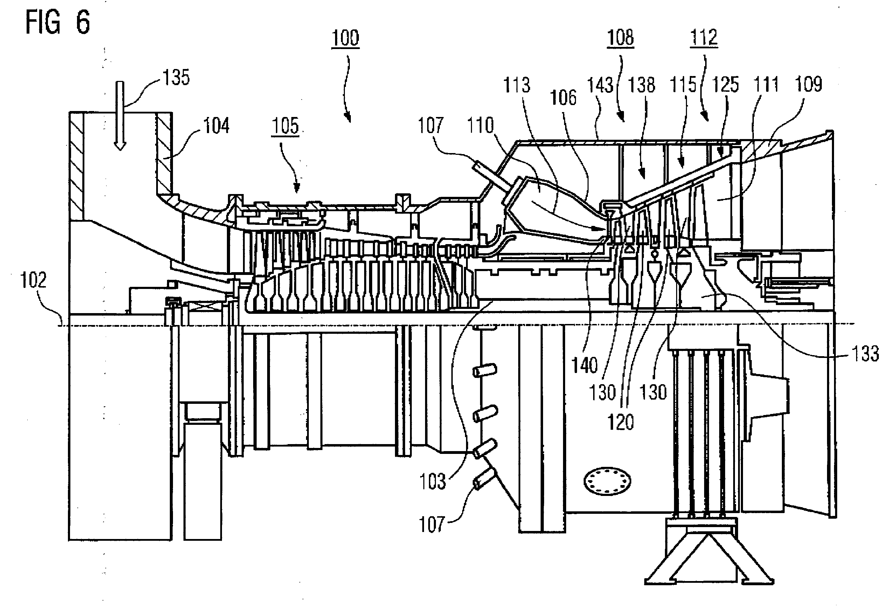

Figur 1 zeigt einen Ausschnitt aus einer Turbinenschaufel 10, 120, 130 (Fig. 4, 6) in einer schematischen Darstellung.
Die folgenden Erläuterungen gelten auch für andere Bauteile, die Löcher aufweisen, wie z.B. Hitzeschildelemente 155 (Fig. 5).
Die Turbinenschaufel 10 ist mit einer Basisplatte 403 verbunden und weist eine Anzahl von Kühlluftöffnungen 14 auf, von denen hier nur diejenigen dargestellt sind, die sich im Bereich der Vorderkante 409 der Turbinenschaufel 10 befinden. Ebenso wie die Turbinenschaufel 10 weist auch die Basisplatte 403 Kühlluftöffnungen 16 auf, deren Durchmesser im vorliegenden Beispiel größer ist, als der Durchmesser der Kühlluftöffnungen 14 in der Turbinenschaufel 10 selbst.

Das Kühlfluid, in der Regel Kühlluft, wird den Kühlluftöffnungen 14 der Turbinenschaufel durch nicht dargestellte Kühlluftkanäle, die im Inneren der Turbinenschaufel 10 angeordnet sind, zugeführt.
Die Turbinenschaufel 10 sowie die Basisplatte 403 sind mit einer Beschichtung versehen, um sie gegen Oxidation und/oder Korrosion zu schützen. Als Beschichtung kommt beispielsweise eine mCrAlX-Beschichtung in Frage. Über dieser Beschichtung kann eine weitere Beschichtung als thermische Barriere (TBC-Beschichtung) zur thermischen Isolation vorhanden sein.

Wenn diese Beschichtungen verschlissen sind oder bei bestimmten Wartungsarbeiten werden die Beschichtungen von der Turbinenschaufel entfernt. Anschließend wird eine neue Beschichtung aufgetragen.

Vor dem Auftragen der neuen Beschichtung werden die Kühlluftöffnungen 14 bzw. 16 mit einem Füllmaterial 20, 22 verschlossen, um zu verhindern, dass sich die Öffnungen 14, 16 beim Beschichten mit Beschichtungsmaterial füllen und so die wirksame Strömungsquerschnittsfläche der Öffnungen verringern.

Das Füllmaterial 20, 22, mit dem die Öffnungen verschlossen werden, ist ein aushärtbarer Werkstoff, der im ausgehärteten Zustand eine Leitfähigkeit besitzt, die im Wesentlichen der des Grundmaterials der Turbinenschaufel 10 entspricht.

Nachfolgend wird die Zusammensetzung des aushärtbaren Werkstoffes beschrieben.
Der aushärtbare Werkstoff ist im vorliegenden Ausführungsbeispiel ein keramischer Werkstoff der Ketten aus Si-O-C- und/oder Si-O-Si-Ketten, vorzugsweise aus Polysiloxan, enthält und der vorzugsweise auch zumindest ein Bindemittel und zumindest einen Füllstoff umfasst.
Das Bindemittel und/oder der Füllstoff umfasst bzw. umfassen dabei zumindest eine elektrisch leitfähige Komponente. Es können ggf. auch mehrere elektrisch leitfähige Komponenten vorhanden sein.
Als elektrisch leitfähige Komponenten kommen dabei Kohlenstoff und/oder Metallpulver in Frage.
Als Bindemittel können anorganische und/oder organische Binder oder siliziumorganische Bindemittel, beispielsweise Siloxane oder Silicone, Verwendung finden.
Mögliche Zusammensetzungen des keramischen Materials sind in der Tabelle 1 dargestellt.

**Tabelle 1:**

| C1-Paste | C2-Paste | Polysiloxan | Metall |
|---|---|---|---|
| Vol.% | Vol.% | Vol.% | Vol.% |
| | | | |
| 90 | 0 | 10 | 0 |
| 0 | 80 | 20 | 0 |
| 45 | 45 | 10 | 0 |
| 30 | 30 | 20 | 20 |
| 70 | 0 | 10 | 20 |
| 0 | 0 | 70 | 30 |

| | | | |
|---|---|---|---|
| C1 = beispielsweise Graphit als elektrisch leitfähiges Material (Partikeldurchmesser: ca. 1 µm, Mischung Graphit/Binder in Vol%: 65 Graphit/35 Binder) C2 = beispielsweise Graphit als elektrisch leitfähiges Material (Partikeldurchmesser: ca. 11 µm, Mischung Graphit/Binder in Vol%: 65 Graphit/35 Binder) Me: Metall bzw. Metalllegierung des Grundwerkstoffes (Partikeldurchmesser: ca. 25 µm) | | | |

Weitere mögliche Zusammensetzungen des keramischen Materials sind in der Tabelle 2 dargestellt.

**Tabelle 2:**

| C3-Paste | C4-Paste | Polysiloxan | Metall |
|---|---|---|---|
| Vol.% | Vol.% | Vol.% | Vol.% |
| | | | |
| 90 | 0 | 10 | 0 |
| 0 | 80 | 20 | 0 |
| 45 | 45 | 10 | 0 |
| 25 | 35 | 20 | 20 |
| 70 | 0 | 10 | 20 |
| 0 | 0 | 80 | 20 |

| | | | |
|---|---|---|---|
| C3 = beispielsweise Graphit als elektrisch leitfähiges Material (Partikeldurchmesser: ca. 0.1 µm, Mischung Graphit/Binder in Vol%: 65 Graphit/35 Binder) C4 = beispielsweise Graphit als elektrisch leitfähiges Material (Partikeldurchmesser: ca. 5.5 µm, Mischung Graphit/Binder in Vol%: 65 Graphit/35 Binder) Metall bzw. Metalllegierung des Grundwerkstoffes (Partikeldurchmesser: ca. 15 µm) | | | |

Neben dem Bindemittel kann der keramische Werkstoff auch ein Lösungsmittel, beispielsweise ein Lösungsmittel auf Alkohol- oder Terpeniolbasis, umfassen, um eine fließfähige Dispersion des Bindemittels und des Füllmaterials zu erzeugen. Die Viskosität der Dispersion lässt sich durch die Art und die Menge des Lösungsmittels beeinflussen. Beispielsweise erhöht ein höherer Lösungsmittelanteil die Viskosität der Dispersion. Der Volumenanteil der Füllstoffe beträgt zwischen 20 und 60 vol%.

Der Kohlenstoff und/oder das Metallpulver können insbesondere Partikel mit verschiedenen Durchmessern im Nanometer- und/oder Mirkometerbereich (kleiner 500µm) aufweisen. Vorzugsweise sind mindestens zwei Partikelgrößen vorhanden, wobei beispielsweise der Kohlenstoff eine andere Partikelgröße aufweist als das Metallpulver. Es ist aber auch möglich, dass bereits der Kohlenstoff oder bereits das Metallpulver in zwei Partikelgrößen vorliegen. Beispiele für Werkstoffe, in denen zwei oder mehr Partikelgrößen vorhanden sind, lassen sich ebenfalls Tabelle 1 oder 2 entnehmen.

Die Partikeldurchmesser sind dabei für das Verdichtungsverhalten des Werkstoffes, die Porenverteilung des Werkstoffes nach dem Vernetzen sowie die Reaktivität des Werkstoffes mit der Gasphase von Bedeutung. Mit einer höheren Anzahl an verschiedenen Partikeldurchmessern lässt sich z.B. eine höhere Verdichtung des Werkstoffes erzielen als mit lediglich einem einzigen Partikeldurchmesser.

Der thermische Ausdehnungskoeffizient des keramischen Werkstoffes lässt sich durch die Art des Füllstoffes, insbesondere durch den Anteil an Metallpulver im Füllstoff, variieren. Ein zu hoher Metallanteil kann jedoch zu einer zu starken Haftung des keramischen Werkstoffes am Grundwerkstoff der Turbinenschaufel führen, sodass das Entfernen des keramischen Werkstoffes nach dem Beschichten erschwert ist. Außer durch den Metallanteil wird die Haftung des keramischen Werkstoffes am Substrat auch durch die bei der Wärmebehandlung zum Aushärten des keramischen Werkstoffes herrschende Temperatur beeinflusst. Eine höhere Temperatur führt dabei zu einem stärkeren Haften des keramischen Werkstoffes, insbesondere der Metallanteile des keramischen werkstoffes, am Grundwerkstoff. Auch das Verdichtungsverhalten des keramischen Werkstoffes hängt von der beim Aushärten herrschenden Temperatur ab. Schließlich beeinflusst der Kohlenstoff- und/oder Metallanteil des Füllmaterials die elektrische Leitfähigkeit des keramischen Werkstoffs und damit auch dessen Wärmeleitfähigkeit. Der Kohlenstoff- und/oder Metallanteil im Füllstoff wird in der Regel so gewählt werden, dass die elektrische Leitfähigkeit und/oder der thermische Expansionskoeffizient des keramischen Werkstoffes nicht zu sehr von den entsprechenden Werten des Grundwerkstoffes der Turbinenschaufel abweicht bzw. abweichen. Dies kann beispielsweise dadurch erreicht werden, dass als eine Metallkomponente des Füllstoffes das Metall oder die Metalllegierung des Grundmaterials gewählt wird, Bei der Wahl der Menge des zugegebenen Metallpulvers sollte, wie bereits weiter oben erwähnt, darauf geachtet werden, dass beim Aushärten keine zu innige Verbindung des keramischen Werkstoffes mit dem Grundwerkstoff entsteht, da diese das Entfernen des Füllstoffes nach dem Beschichtungsprozess erschweren würde.

Das Einbringen des keramischen Werkstoffes in die Öffnungen 14 der Turbinenschaufel 10 ist in den Figuren 2 und 3 dargestellt.

Im in Figur 2 dargestellten Verfahren zum Einbringen des keramischen Werkstoffes 20 liegt der keramische Werkstoff 20 als Paste vor. Mittels einer spachtelartigen Vorrichtung 24 wird die Masse in die Öffnungen 14 eingestrichen, sodass die Oberfläche 21 des keramischen Werkstoffes 20 nach dem Einstreichen in die Öffnungen bündig mit der Oberfläche 11 der Turbinenschaufel 10 abschließt, d.h. nicht über die Oberfläche 11 der Turbinenschaufel vorsteht. Statt einem Einstreichen der Paste in die Öffnungen ist auch ein Einspritzen der Paste möglich.

Eine Alternative zum Einbringen des keramischen Werkstoffes ist in Figur 3 dargestellt.

Diese Alternative eignet sich insbesondere für das Einbringen des keramischen Werkstoffes in Öffnungen 16 mit relativ großem Durchmesser, wie sie etwa in der Basisplatte 12 zu finden sein können. Gemäß der zweiten Variante wird der keramische Werkstoff im teilvernetzten, sog. grünen Zustand als Formkörper in die Öffnungen eingesetzt.
Ebenso kann ein nicht mehr auszuhärtender Formkörper verwendet werden,
Ein Formkörper kann dabei stift-, knopf-, zapfenförmig, etc. ausgebildet sein. Er wird derart eingesetzt, dass seine Oberfläche 23 mit der Oberfläche 11 der Turbinenschaufel 10 bündig abschließt. Insbesondere ist es möglich, den Formkörper an dem Querschnitt der zu verfüllenden Öffnung anzupassen.

Der Formkörper kann beispielsweise aus einer Folie ausgestanzt werden, welche aus dem keramischen Werkstoff im grünen Zustand besteht. Folien oder Tapes des keramischen Werkstoffes im grünen Zustand können auch dazu verwendet werden, flächige Abschnitte der Turbinenschaufel während des Beschichtungsvorganges zu schützen.
Das Füllmaterial besteht erfindungsgemäß entweder aus Si-O-Si-Ketten (Keramisierung an Luft) und/oder aus Si-O-C-Ketten (Keramisierung in Argon, Vakuum).
Die Si-O-C-Ketten oder Si-O-Si-Ketten sind vorzugsweise aus einem Polysiloxan-Harz hergestellt. Polysiloxan-Harze sind polymer-keramische Vorstufen der Strukturformel XSiO_{1,5}, wobei X = -CH₃, -CH, -CH₂, -C₆H₈ etc. sein kann. Das Material wird thermisch vernetzt, wobei anorganische Bestandteile (Si-O-Si-Ketten) und organische Seitenketten überwiegend aus X nebeneinander vorliegen. Anschließend werden die Vorstufen über eine Temperaturbehandlung in Ar, N₂, Luft- oder VakuumAtmosphäre bei Temperaturen zwischen 600°C und 1200°C keramisiert. Dabei wird das polymere Netzwerk zersetzt und über thermische Zwischenstufen von amorphen bis kristalline Phasen neu strukturiert, wobei ausgehend von Polysiloxan-Vorstufen ein Si-O-C-Netzwerk entsteht,
Vorzugsweise kann auch ein Gemisch aus Si-O-C-Ketten und Si-O-Si-Ketten verwendet werden.

Ebenso können auch von Vorstufen des Typs Polysilan (Si-Si), Polycarbosilan (Si-C), Polysilazan (Si-N) oder Polybarosilazan (Si-B-C-N) verwendet werden.

Wenn der keramische Werkstoff als Paste in die Öffnungen eingestrichen oder eingespritzt wird, erfolgt anschließend eine Vernetzung der Polymerbestandteile, also beispielsweise des anorganischen und/oder organischen Binders oder des siliziumorganischen Bindemittels, mittels eines Heizschrittes, der bei Temperaturen von etwa 200°C stattfindet, um eine vorläufige Formstabilität des keramischen Materials vor dem Durchführen des Beschichtungsverfahrens herzustellen.
Wenn, wie in Figur 3 dargestellt, der keramische Werkstoff als grüner Formkörper eingesetzt wird, so muss zuvor eine Vernetzung oder zumindest eine Teilvernetzung des keramischen Werkstoffes erfolgt sein, um die Formstabilität des Formkörpers bereits vor dem Einsetzen in die Öffnungen zu gewährleisten. Die Vernetzung bzw. Teilvernetzung erfolgt dabei durch eine geeignete Wärmebehandlung mit Temperaturen von nicht mehr als ca. 200°C, in denen der anorganische und/oder organische Binder bzw. das siliziumorganische Bindemittel eine zumindest teilvernetzte Polymerarchitektur annimmt.

Im weiteren Verlauf erfolgt eine pyrolitische Umwandlung (Brennen bzw. Keramisierung) des in die Öffnungen eingebrachten Werkstoffes bei Temperaturen oberhalb ca. 400 bis 450°C, um die Keramisierung des Werkstoffes herbeizuführen, Dieser Brennvorgang kann in den Beschichtungsprozess integriert sein. Beispielsweise umfasst ein Beschichtungsprozess zum Auftragen einer MCrAlX-Beschichtung einen Vorwärmvorgang, bei dem die genannten Temperaturen erreicht oder übertroffen werden.

Beim Brennen verdichtet sich der keramische Werkstoff. Außerdem werden Poren im Werkstoff mit offener oder geschlossener Porosität ausgebildet.
Das verdichtungsverhalten und die Porenverteilung im ausgehärteten Werkstoff hängen dabei zum einen von der Wahl des Bindemittels, beispielsweise von der Kohlenstoffkonzentration im Bindemittel, und zum anderen von den Partikeldurchmessern des Füllstoffes ab. Bei der Wahl des Bindemittels sowie geeigneter Partikeldurchmesser des Füllstoffes sollte darauf geachtet werden, dass die resultierenden Poren eine ausreichende Stabilität des ausgehärteten Werkstoffes gewährleisten und nicht so groß sind, dass das Beschichtungsmaterial durch die Poren hindurch die Wände der Öffnungen erreicht.

Der Brennvorgang findet in Abhängigkeit von der Art des verwendeten Bindemittels und der Art der herzustellenden Keramik entweder unter Luftausschluss, beispielsweise in einer Inertgasatmosphäre, oder in einer Luftatmosphäre statt.

Wenn ein auf Kohlenstoff basierendes Bindemittel auf Basis eines organischen Binders Verwendung findet, findet der Brennvorgang unter Luftausschluss statt, damit der Kohlenstoff nicht zu CO oder CO₂ oxidiert wird. Beim Verbrennungsprozess unter Inertgas verbleiben bis zu 90% des Kohlenstoffs im Werkstoff. Wenn der Füllstoff Metallpulver umfasst, können dabei metallcarbidische Phasen entstehen. Einige Metallcarbide, beispielsweise Aluminiumcarbid, bieten die Möglichkeit, den ausgehärteten keramischen Werkstoff nach Abschluss des Beschichtungsprozesses mittels Wasser aus den Öffnungen herauszuspülen, da sie mit Wasser reagieren und löslich sind. Es können auch Metalle ausgewählt werden, die keine Karbide bei den Beschichtungs- oder Bearbeitungstemperaturen bilden.

Wenn siliziumorganische Bindemittel, wie Siloxane oder Silikone, Verwendung finden, so können beim Brennen siliziumkarbidische Phasen (beim Brennen unter Luftausschluss) oder siliziumoxidische Phasen (beim Brennen in Luft) erzeugt werden. Mittels der Zusammensetzung der Atmosphäre, unter der der Brennvorgang stattfindet sowie der Zusammensetzung des siliziumorganischen Bindemittels kann dabei eingestellt werden, wie hoch nach dem Brennvorgang der Anteil oxidischer Phasen im Verhältnis zu carbidischen Phasen ist,

Beim Brennen ist ein stufenloses Einstellen Anteils an Siliziumoxid im keramischen Werkstoff nach dem Brennvorgang im Bereich zwischen 0% und 100% Siliziumoxid möglich. Dabei lassen sich 0% Siliziumoxid beispielsweise durch das Verwenden von anorganischen und/oder organischen Bindern als Bindemittel realisieren,

Die Zusammensetzung des Bindemittels, die Zusammensetzung des Füllmaterials, sowie die Temperatur und die Dauer des Brennvorgangs können im erfindungsgemäßen keramischen Werkstoff derart gewählt werden, dass dieser lediglich im Bereich seiner Oberfläche bzw. seiner Kontaktfläche 13 zum Metall vollständig aushärtet. Im Inneren seines Volumens befindet sich der keramische Werkstoff dann in einem nicht ausgehärteten, vernetzten oder teilvernetzten Zustand. Dadurch wird das Entfernen des keramischen Werkstoffes nach dem Beschichtungsvorgang mittels eines Strahlprozesses erleichtert.

Das Entfernen des keramischen Werkstoffes kann, wenn seine Zusammensetzung und die Aushärtungsbedingungen geeignet gewählt worden sind, mittels Trockeneisstrahlen aus den Öffnungen entfernt werden, Das Entfernen mittels Trockeneisstrahlen beeinträchtigt beispielsweise metallische MCrAlX-Beschichtungen nicht. Außerdem ist ein "Auswaschen" der Beta-Phase der MCrAlX-Beschichtung gänzlich ausgeschlossen.

Das erfindungsgemäße keramische Material kann gegebenenfalls zusätzlich in Spuren, d.h. mit einem Volumenanteil von kleiner ca. 1%, Additive umfassen. Als Additive kommen etwa Katalysatoren in Frage, die eine Vernetzung des Bindemittels bei Temperaturen unterhalb von ca. 200°C fördern. Als ein solcher Katalysator kann z.B. Platin eingesetzt werden. Auch Additive zum Beeinflussen der Oberflächenspannung des Lösungsmittels und damit zur gezielten Substrathaftung sind denkbar.

Im Ausführungsbeispiel wird das erfindungsgemäße Verfahren zum Schützen von Öffnungen eines aus einem Grundwerkstoff auf Metallbasis hergestellten Bauteils gegen ein Eindringen von Beschichtungsmaterial bei einem Wiederbeschichten des Bauteils beschrieben. Das Verfahren kann aber auch bei einem Erstbeschichten vorteilhaft zum Einsatz kommen, wenn vor dem Erstbeschichten bereits zu schützende Öffnungen im Bauteil vorhanden sind.

Ein weiterer Anwendungsbereich des erfindungsgemäßen keramischen Werkstoffes bietet sich bei Lötprozessen an. So werden etwa beim Löten von Turbinenschaufeln sog. "Stop-offs" benutzt, um Kühlluftbohrungen gegen das Eindringen von Lot zu schützen. Statt der "Stop-offs" kann in vorteilhafter Weise der erfindungsgemäße keramische Werkstoff zum Schutz der Kühlluftbohrungen zum Einsatz kommen. Der keramische Werkstoff muss nach dem Löten nicht aus den Öffnungen entfernt werden und kann für einen anschließenden Beschichtungsprozess in den Öffnungen verbleiben. So können Prozessschritte eingespart und Durchlaufzeiten gesenkt werden.

Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt) .

Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.

Auf der MCrAlX kann noch eine Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt oder z.B, atmosphärisches Plasmaspritzen (APS) poröse, mikro- und makrorissbehaftete Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130 bei dem das erfindungsgemäße verfahren benutzt wird.

Die Schaufel 120, 130 kann hohl oder massiv ausgeführt sein.. Wenn die Schaufel 120, 130 gekühlt werden soll, ist sie hohl und weist ggf. noch Filmkühllöcher 418 (gestrichelt angedeutet) auf.

Die Figur 5 zeigt eine Brennkammer 110 einer Gasturbine 100. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.
Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.
Diese Schutzschichten können ähnlich der Turbinenschaufeln sein, also bedeutet beispielsweise MCrAlx: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.

Auf der MCrAlX kann noch eine beispielsweise keramische Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Hitzeschildelemente 155 nach ihrem Einsatz gegebenenfalls von Schutzschichten befreit werden müssen (z,B. durch Sandstrahlen). Danach erfolgt eine Entfernung der Korrosions- und/oder Oxidationsschichten bzw. -produkte. Gegebenenfalls werden auch noch Risse in dem Hitzeschildelement 155 repariert. Danach erfolgt eine Wiederbeschichtung der Hitzeschildelemente 155, bei dem das erfindungsgemäße Verfahren benutzt wird, und ein erneuter Einsatz der Hitzeschildelemente 155.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Filmkühllöcher (nicht dargestellt) auf.

Die Figur 6 zeigt beispielhaft eine Gasturbine 100 in einem Längsteilschnitt.

Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierungen Teil der Offenbarung.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

## Patentansprüche

1. Verfahren zum Schützen von Öffnungen (14, 16) eines Bauteils (10) bei einem Bearbeitungsprozess gegen ein Eindringen von Material,
in dem die Öffnungen (14, 16) vor dem Bearbeitungsprozess mit einem Füllmaterial (20, 22) verschlossen werden
und in dem das Füllmaterial (20, 22) nach dem Bearbeitungsprozess wieder entfernt wird,
**dadurch gekennzeichnet, dass**
das Füllmaterial Si-O-C- und/oder Si-O-Si-Ketten als zumindest einen Füllstoff enthält.

2. Verfahren nach Anspruch 1,
**dadurch gekennzeichnet, dass**
Polysiloxan verwendet wird,
das Si-O-C und/oder Si-O-Si-Ketten enthält.

3. verfahren nach Anspruch 1 oder 2,
**dadurch gekennzeichnet,**
**dass** das Füllmaterial (20, 22)
zumindest ein Bindemittel und
zumindest einen Füllstoff enthält und
**dass** der zumindest eine Füllstoff Kohlenstoff und/oder einen Kohlenstoff-Precursor als zumindest eine elektrisch leitfähige Komponente umfasst,
um die elektrische Leitfähigkeit des Füllmaterials (20, 22) an die elektrische Leitfähigkeit des Grundwerkstoffes anzupassen,
insbesondere bis zu 50% der Leitfähigkeit.

4. Verfahren nach Anspruch 1 oder 2,
**dadurch gekennzeichnet,**
**dass** das Füllmaterial (20, 22)
zumindest ein Bindemittel und
zumindest einen Füllstoff umfasst und
**dass** der zumindest eine Füllstoff Kohlenstoff und/oder einen Kohlenstoff-Precursor und Metall als zumindest eine elektrisch leitfähige Komponente umfasst,
um die elektrische Leitfähigkeit des Füllmaterials (20, 22) an die elektrische Leitfähigkeit des Grundwerkstoffes anzupassen,
insbesondere bis zu 50% der Leitfähigkeit.

5. Verfahren nach Anspruch 1 oder 2,
**dadurch gekennzeichnet,**
**dass** das Füllmaterial (20, 22)
zumindest ein Bindemittel und
zumindest einen Füllstoff umfasst und
**dass** der zumindest eine Füllstoff Metall als zumindest eine elektrisch leitfähige Komponente umfasst,
um die elektrische Leitfähigkeit des Füllmaterials (20, 22) an die elektrische Leitfähigkeit des Grundwerkstoffes anzupassen,
insbesondere bis zu 50% der Leitfähigkeit.

6. Verfahren nach Anspruch 3, 4 oder 5,
**dadurch gekennzeichnet, dass**
der Binder den Kohlenstoff und/oder den Kohlenstoff-Precursor darstellt.

7. Verfahren nach Anspruch 1, 2, 3, 4 oder 5,
**dadurch gekennzeichnet,**
**dass** das Füllmaterial,
insbesondere das Polysiloxan,
ein aushärtbares Füllmaterial (20, 22) ist und
**dass** die Aushärtung nach dem Füllen der Öffnungen (14, 16) mit dem Füllmaterial (20, 22) erfolgt.

8. Verfahren nach Anspruch 7,
**dadurch gekennzeichnet,**
**dass** das Aushärten mittels einer Wärmebehandlung geschieht und
**dass** diese Wärmebehandlung insbesondere in eine Wärmebehandlung des Beschichtungsprozesses integriert ist.

9. Verfahren nach einem der Ansprüche 1 bis 7,
**dadurch gekennzeichnet, dass**
das Füllmaterial (20) in mindestens einen Teil der Öffnungen (14, 16) als Paste eingebracht wird.

10. Verfahren nach einem der Ansprüche 1 bis 9,
**dadurch gekennzeichnet, dass**
das Füllmaterial (22) in mindestens einen Teil der Öffnungen (14, 16) als vorgeformter teilvernetzter Füllkörper (22) eingebracht wird.

11. Verfahren nach einem der Ansprüche 7 bis 10,
**dadurch gekennzeichnet, dass**
die Materialeigenschaften des Füllmateriales (20, 22) und/oder die Aushärtungsbedingungen derart gewählt sind, dass das Füllmaterial (20, 22) nur teilweise aushärtet,

12. Verfahren nach Anspruch 11,
**dadurch gekennzeichnet, dass**
die Materialeigenschaften des Füllmateriales (20, 22) und/oder die Aushärtungsbedingungen derart gewählt sind, dass ein vollständiges Aushärten des Füllmaterials (20, 22) nur im Bereich der Kontaktflächen (13) zum Grundwerkstoff des Bauteils (10) erfolgt.

13. Verfahren nach einem der Ansprüche 1 bis 12,
**dadurch gekennzeichnet, dass**
das Entfernen des Füllmateriales (20, 22) mittels eines Strahlverfahrens erfolgt.

14. Verfahren nach Anspruch 13,
**dadurch gekennzeichnet, dass**
das Entfernen des Füllmateriales (20, 22) mittels eines CO₂-Strahlverfahrens,
insbesondere Trockeneisstrahlen erfolgt.

15. Verfahren nach Anspruch 1,
**dadurch gekennzeichnet, dass**
der Bearbeitungsprozess ein 8eschichtungsprozess ist.

16. Verfahren nach Anspruch 1,
**dadurch gekennzeichnet, dass**
der Hearbeitungsprozess ein Lötprozess ist.

17. Verfahren nach Anspruch 1,
**dadurch gekennzeichnet, dass**
der Bearbeitungsprozess ein Sputterprozess ist.

18. Keramischer Werkstoff,
zur Verwendung als Füllmaterial in einem Verfahren nach einem der Ansprüche 1 bis 17,
der Si-O-Si und/oder Si-O-C-Ketten und
insbesondere Polysiloxan enthält.

19. Keramischer Werkstoff nach Anspruch 18,
welcher zumindest ein Bindemittel und zumindest einen Füllstoff umfasst,
wobei der zumindest eine Füllstoff zumindest eine elektrisch leitfähige Komponente umfasst.

20. Keramischer Werkstoff nach Anspruch 19,
bei dem das Bindemittel einen Kohlenstoff-Precursor darstellt.

21. Keramischer Werkstoff nach Anspruch 19, bei welchem der Füllstoff Partikel in mindestens zwei Partikelgrößen umfasst.

22. Keramischer Werkstoff nach Anspruch 19, 20 oder 21, welcher Kohlenstoff als elektrisch leitfähige Komponente umfasst.

23. Keramischer Werkstoff nach Anspruch 19, 20 oder 21, welcher Metallpulver als elektrisch leitfähige Komponente umfasst.

24. Keramischer Werkstoff nach Anspruch 18 oder 19,
welcher ein siliaiurnorganisches Bindemittel als Kohlenstoff-Precursor umfasst.

25. Keramischer Werkstoff nach einem der Ansprüche 18 bis 24,
welcher ein Lösungsmittel zum Herstellen einer Dispersion des Bindemittels und der zumindest einen elektrisch leitfähigen Komponente umfasst.

26. Keramischer Werkstoff nach Anspruch 25,
der ein Lösungsmittel auf Alkoholbasis umfasst.

27. Keramischer Werkstoff nach Anspruch 25,
der ein Lösungsmittel auf Terpeniolbasis umfasst.

28. Keramischer Werkstoff nach Anspruch 21,
bei dem die Partikelgrößen im Bereich von 0.01µm bis 100µm liegen.
